# EUROPEAN PATENT SPECIFICATION

(11) **EP 2 516 550 B1**
(45) Date of publication and mention of the grant of the patent: **02.07.2014**
(21) Application number: 10795693.0
(22) Date of filing: 20.12.2010
(51) Int. Cl.: H05K 3/18

(54) **Aromatic Polycarbonate Composition**
Aromatische Polycarbonatzusammensetzung
Composition de polycarbonate aromatique

(30) Priority: 21.12.2009 EP 09180079; 28.05.2010 EP 10164276
(43) Date of publication of application: 31.10.2012
(73) Proprietor: Mitsubishi Chemical Europe GmbH, 40549 Düsseldorf (DE)
(72) Inventor: SCHRAUWEN, Bernardus Antonius Gerardus, NL-6029 RN Sterksel (NL)
(74) Representative: Renkema, Jaap
(86) International application number: PCT/EP2010/070227
(87) International publication number: WO 2011/076729

(56) References cited:
- WO-A1-01/23189
- WO-A1-2009/141799
- WO-A2-2009/024496

## Description

The present invention relates to an aromatic polycarbonate composition further comprising a laser direct structuring additive. The invention also relates to a process for producing such a composition, to a moulded part containing this composition and to a circuit carrier containing such moulded part.

Polymer compositions comprising a polymer and a laser direct structuring (LDS) additive which additive is capable of being activated by laser radiation and thereby forming elemental metal nuclei, are for example described in US-B2-7060421 and WO-A-2009024496. Such polymer compositions can advantageously be used in a LDS process for producing a non-conductive part on which conductive tracks are to be formed by irradiating areas of said part with laser radiation to activate the plastic surface at locations where the conductive path is to be situated and break down the laser direct structuring additive(s) and release metal nuclei, and subsequently metalizing the irradiated areas to accumulate metal on these areas. WO-A-2009024496 describes aromatic polycarbonate compositions containing a metal compound capable of being activated by electromagnetic radiation and thereby forming elemental metal nuclei and 2,5-50 mass% of a rubber like polymer, the latter being added to reduce degradation of the polycarbonate due to the presence of such metal compound in aromatic polycarbonate compositions. However, the presence of rubber-like polymer in substantial amount is disadvantageous in some applications, in particular high temperature applications, such as parts that require soldering. As shown in WO-A-2009024496, compositions comprising aromatic polycarbonate and laser direct structuring additive,but no or only small amount of rubber like polymer results in degradation of the polycarbonate and thus resulting in a decrease of the toughness as for example expressed in Izod Notched impact strength performance.

The object of the present invention is to provide an aromatic polycarbonate composition comprising a laser direct structuring additive but no or only small amount of rubber like polymer with improved toughness.

This object is achieved in that the aromatic polycarbonate composition comprises the following components:
a) aromatic polycarbonate in an amount higher than 85 wt%,
b) laser direct structuring additive in an amount of at least 0,5 wt%,
c) sulphonate salt in an amount of at least 0,001 wt.%, and
d) 0-2,4 wt.%. of rubber like polymer
wherein the mass% is calculated relative to the sum of components a), b), c) and d).

The amounts given for components a), b), c) and d) are thus relative to the total weight of components a), b), c) and d).

It has surprisingly been found that with the composition according to the invention the toughness as for example expressed in Izod Notched impact strength can be remarkably increased. It has surprisingly been found that the Izod Notched impact strength at 23 °C (measured at a sample thickness of 3.2 mm or less according to ISO 180/4A) of a molded part of the polycarbonate composition can be increased to a value higher than 20 kJ/m², even higher than 30 kJ/m², even higher than 40 kJ/m², even higher than 50 kJ/m², and even higher than 60 kJ/m².

An additional advantage of the composition according to the invention is that a molded part of the polycarbonate composition is capable of achieving UL94 V0 rating at a thickness of 3.2 mm (±10%) and even capable of achieving UL94 V0 rating at a thickness of 1.6 mm (±10%). Thus the composition according to the invention provides a flame retardant aromatic polycarbonate composition that is capable of being used in a laser direct structuring process, while at the same time the inherent properties of aromatic polycarbonate such as toughness can be provided to a substantial level.

An additional advantage of the composition according to the invention is that a molded part of the polycarbonate composition is capable of having a Vicat B50 higher than 140 °C (Vicat Softening Temperature measured according to ISO 306 with a load of 50 N at a rate of 50°C/hour). Thus the composition according to the invention provides a flame retardant aromatic polycarbonate composition that is capable of being used in a laser direct structuring process, while providing one or more inherent properties of aromatic polycarbonate such as Vicat and at the same time providing toughness to a substantial level.

The present invention therefore also relates to the use of a sulphonate salt in a composition comprising aromatic polycarbonate and a laser direct structuring additive (and being substantially free of a rubber like polymer) for increasing the Izod Notched impact strength at 23 °C (measured at a sample thickness of 3.2 mm or less according to ISO 180/4A) of a molded part of the polycarbonate composition to a value higher than 20 kJ/m², even higher than 30 kJ/m², even higher than 40 kJ/m², even higher than 50 kJ/m², and even higher than 60 kJ/m². As used herein, substantially free of rubber like polymer means that the amount of rubber like polymer in the composition according to the invention is at most 2,4 wt%, relative to the sum of the weights of aromatic polycarbonate, laser direct structuring additive, rubber like polymer and sulphonate salt. Preferably, the amount of rubber like polymer is less than 2 wt% more preferably less than 1,5 wt%, more preferably less than 1 wt% and even more preferably 0 wt% of rubber like polymer.

The polycarbonate composition according to the invention contains aromatic polycarbonate in an amount higher than 85 wt%, preferably in an amount higher than 90 wt%. Suitable aromatic polycarbonates are polycarbonates made from at least a divalent phenol and a carbonate precursor, for example by means of the commonly known interfacial polymerization process or the melt polymersiation method. Suitable divalent phenols that may be applied are compounds having one or more aromatic rings that contain two hydroxy groups, each of which is directly linked to a carbon atom forming part of an aromatic ring. Examples of such compounds are 4,4'-dihydroxybiphenyl, 2,2-bis(4-hydroxyphenyl)propane (bisphenol A), 2,2-bis(4-hydroxy-3-methylphenyl) propane, 2,2-bis-(3-chloro-4-hydroxyphenyl)-propane, 2,2-bis-(3,5-dimethyl-4-hydroxyphenyl)-propane, 2,4-bis-(4-hydroxyphenyl)-2-methylbutane, 2,4-bis-(3,5-dimethyl-4-hydroxyphenyl)-2-methylbutane, 4,4-bis(4-hydroxyphenyl)heptane, bis-(3,5-dimethyl-4-hydroxyphenyl)-methane, 1,1-bis-(4-hydroxyphenyl)-cyclohexane, 1,1-bis-(3,5-dimethyl-4-hydroxyphenyl)-cyclohexane, 2,2-(3,5,3',5'-tetrachloro-4,4'-dihydroxydiphenyl)propane, 2,2-(3,5,3',5'-tetrabromo-4,4'-dihydroxydiphenyl)propane, (3,3'-dichloro-4,4'-dihydroxyphenyl)methane, bis-(3,5-dimethyl-4-hydroxyphenyl)-sulphon, bis-4-hydroxyphenylsulphon, bis-4-hydroxyphenylsulphide.

The carbonate precursor may be a carbonyl halogenide, a halogen formate or carbonate ester. Examples of carbonyl halogenides are carbonyl chloride and carbonyl bromide. Examples of suitable halogen formates are bis-halogen formates of divalent phenols such as hydroquinone or of glycols such as ethylene glycol. Examples of suitable carbonate esters are diphenyl carbonate, di(chlorophenyl)carbonate, di(bromophenyl)carbonate, di(alkylphenyl)carbonate, phenyltolylcarbonate and the like and mixtures thereof. Although other carbonate precursors may also be used, it is preferred to use the carbonyl halogenides and in particular carbonylchloride, also known as phosgene.

The aromatic polycarbonates in the composition according to the invention may be prepared using a catalyst, an acid acceptor and a compound for controlling the molecular mass.

Examples of catalysts are tertiary amines such as triethylamine, tripropylamine and N,N-dimethylaniline, quaternary ammonium compounds such as tetraethylammoniumbromide and quaternary phosphonium compounds such as methyltriphenylfosfoniumbromide.

Examples of organic acid acceptors are pyridine, triethylamine, dimethylaniline and so forth. Examples of inorganic acid acceptors are hydroxides, carbonates, bicarbonates and phosphates of an alkali metal or earth alkali metal.

Examples of compounds for controlling the molecular mass are monovalent phenols such as phenol, p-alkylphenols and para-bromophenol and secondary amines.

Such polycarbonates, their preparation and properties are described in detail in for example Encycl. Polym. Sci. Eng., 11, p. 648-718 (Wiley, New York, 1988) and in Kunststoff Handbuch, 3/1, p. 117-297 (Hanser Verlag, Muenchen, 1992).

The composition according to the invention preferably contains a polycarbonate derived from bisphenol A and phosgene and optionally minor amounts of other compounds having one, two or more than two reactive groups as comonomers, for instance for controlling the melt viscosity.

The polycarbonate composition contains a laser direct structuring additive (component b)) that enables the composition to be used in a laser direct structuring (LDS) process. In a LDS process, a laser beam exposes the LDS additive to place it at the surface of the polycarbonate composition and to release metal nuclei from the LDS additive. As such, the LDS additive is selected such that, upon exposure to a laser beam, metal atoms are activated and exposed and in areas not exposed by the laser beam, no metal atoms are exposed.

Component b) is capable of being activated by laser radiation and thereby forming elemental metal nuclei within the polycarbonate composition. The component b) is a metal-containing (inorganic or organic) compound which as a consequence of absorption of laser radiation liberates metal in elemental form. It is also possible that the radiation is not directly absorbed by the metal-containing compound, but is absorbed by other substances which then transfer the absorbed energy to the metal-containing compound and thus bring about the liberation of elemental metal. The laser radiation may be UV light (wavelength from 100 to 400 nm), visible light (wavelength from 400 to 800 nm), or infrared light (wavelength from 800 to 25 000 nm). Other preferred forms of radiation are X-rays, gamma rays, and particle beams (electron beams, [alpha]-particle beams, and [beta]-particle beams). The laser radiation is preferably infrared light radiation, more preferably with a wavelength of 1064 nm. Examples of LDS additives useful in the present invention include for example copper chromium oxide spinel, copper molybdenum oxide spinel, a copper salt, such as for example copper hydroxide phosphate; copper phosphate and copper sulphate.

The component b) capable of being activated by laser radiation is preferably comprised of electrically non-conductive high-thermal-stability organic or inorganic metal compounds which are preferably insoluble and stable in aqueous acidic or alkaline metalizing baths. Particularly suitable compounds are those which absorb a very large proportion of the light at the wavelength of the incident light. Compounds of this type are described in EP-A-1 274 288. Preference is given here to compounds of metals of the d and f group of the Periodic Table of the Elements with non-metals. The metal-containing compounds are particularly preferably metal oxides, in particular oxides of the d-metals of the Periodic Table of the Elements. Higher metal oxides which contain at least two different kinds of cations and have a spinel structure or spinel-related structure, and which remain unchanged in non-irradiated areas of the moulded part that contains the composition of the present invention are particularly suitable. In one particularly preferred embodiment of the invention, the higher oxides are spinels, in particular copper-containing spinels, such as CuCr₂O₄. Suitable copper-containing spinels are commercially available, an example being PK 3095 from Ferro (DE) or 34E23 or 34E30 from Johnson Matthey (DE). Copper oxides of the formula CuO or Cu₂O are also particularly suitable, and use is preferably made here of nanoparticles, such as NANOARC(R) Copper Oxide from Nanophase Technologies Corporation, Illinois, USA. In another particularly preferred embodiment of the invention, the higher spinel oxide is a manganese-containing spinel. As will be understood by a man skilled in the art also a mixture of metal compounds can be used.

Preferably, the metal compound is represented by the chemical formula AB₂O₄ or B(AB)O₄. The A component of the formulas is a metal cation having a valence of 2 and is selected from the group consisting of cadmium, zinc, copper, cobalt, magnesium, tin, titanium, iron, aluminum, nickel, manganese, chromium, and combinations of two or more of these. The B component of the formulas is a metal cation having a valence of 3 and is selected from the group consisting of cadmium, manganese, nickel, zinc, copper, cobalt, magnesium, tin, titanium, iron, aluminum, chromium, and combinations of two or more of these.

The polymer compositions of the invention have dispersed therein metal compound(s), where the metal compound preferably comprises two or more metal oxide cluster configurations within a definable crystal formation. The overall crystal formation, when in an ideal (i.e., non-contaminated, non-derivative) state, has the following general formula:

AB₂O₄,

where
i. A is selected from the group consisting of cadmium, zinc, copper, cobalt, magnesium, tin, titanium, iron, aluminum, nickel, manganese, chromium, and combinations thereof, which provides the primary cation component of a first metal oxide cluster ("metal oxide cluster 1") typically a tetrahedral structure,
ii. B is selected f from the group consisting of cadmium, manganese, nickel, zinc, copper, cobalt, magnesium, tin, titanium, iron, aluminum, chromium, and combinations thereof and which provides the primary cation component of a second metal oxide cluster ("metal oxide cluster 2") typically an octahedral structure,
iii. where within the above groups A or B, any metal cation having a possible valence of 2 can be used as an "A", and any metal cation having a possible valence of 3 can be used as a "B",
iv. where the geometric configuration of "metal oxide cluster 1" (typically a tetrahedral structure) is different from the geometric configuration of "metal oxide cluster 2" (typically an octahedral structure),
v. where a metal cation from A and B can be used as the metal cation of "metal oxide cluster 2" (typically the octahedral structure), as in the case of an 'inverse' spinel-type crystal structure,
vi. where O is primarily, if not exclusively, oxygen; and
vii. where the "metal oxide cluster 1" and "metal oxide cluster 2" together provide a singular identifiable crystal type structure having heightened susceptibility to electromagnetic radiation.

The concentration of these components b) present in the composition of the present invention is at least 0,5 mass%, preferably at least 1 mass%, more preferably at least 3 mass%, even more preferably at least 4 mass%, and particularly preferably from 5 up to 10 mass%.

The polycarbonate composition preferably comprises an alkali and/or earth alkali metal sulphonate as sulphonate salt. In one embodiment, the composition comprises an alkali metal sulphonate as sulphonate salt. Preferably, the composition comprises a potassium sulphonate as sulphonate salt. More preferably, the composition comprises potassium perfluorobutane sulphonate and/or potassium diphenylsulphone sulphonate as sulphonate salt. Even more preferably, the composition comprises potassium perfluorobutane sulphonate as sulphonate salt.

The weight ratio of sulphonate salt to laser direct structuring additive in the composition according to the invention is preferably at least 0,01:1, more preferably at least 0,015:1 and even more preferably at least 0,02:1. The weight ratio of sulphonate salt to laser direct structuring additive in the composition according to the invention is preferably at most 0,25:1 and more preferably at most 0,2:1.

The composition may contain rubber like polymer in an amount of from 0 up to and including 2,4 mass%. Preferably, the amount of rubber like polymer is less than 2 mass%, more preferably less than 1,5 mass%, more preferably less than 1 mass% and even more preferably 0 mass% of rubber like polymer. In a preferred embodiment of the present invention, the composition does not contain rubber like polymer. The rubber-like polymer is or contains an elastomeric (i.e. rubbery) polymer having preferably a T_{g} less than about 10° C. Examples of elastomeric polymers include polyisoprene; butadiene based rubbers like polybutadiene, styrene-butadiene random copolymer and block copolymer, hydrogenates of said block copolymers, acrylonitrile-butadiene copolymer and butadiene-isoprene copolymer; acrylate based rubbers like ethylene-methacrylate and ethylene-butylacrylate, acrylate ester-butadiene copolymers, for example acrylic elastomeric polymers such as butylacrylate-butadiene copolymer; siloxane based rubbers like polyorganosiloxanes such as for example polydimethylsiloxane, polymethylphenylsiloxane and dimethyl-diphenylsiloxane copolymer; and other elastomeric polymers like ethylene-propylene random copolymer and block copolymer, copolymers of ethylene and α-olefins, copolymers of ethylene and aliphatic vinyl such as ethylene-vinyl acetate, and ethylene-propylene nonconjugated diene terpolymers such as ethylene-propylene-hexadiene copolymer, butylene-isoprene copolymer, and chlorinated polyethylene.

In a preferred embodiment of the invention, the aromatic polycarbonate composition according to the invention preferably further comprises an acid and/or acid salt different than the sulphonate salt. It has surprisingly been found that the simultaneous presence of a sulphonate salt and an acid and/or acid salt different than the sulphonate salt results in a synergetic increase of the toughness, as for example demonstrated by Izod Notched impact strength performance. It has surprisingly been found that the Izod Notched impact strength at 23 °C (measured at a sample thickness of 3.2 mm or less according to ISO 180/4A) of a molded part of an aromatic polycarbonate laser direct structurable composition comprising a sulphonate salt and an acid and/or acid salt (different than the sulphonate salt).can be increased to a value higher than 50 kJ/m², even higher than 60 kJ/m², and even higher than 70 kJ/m².

The present invention therefore further relates to the use of a sulphonate salt and an acid and/or acid salt (different than the sulphonate salt) in a composition comprising aromatic polycarbonate and a laser direct structuring additive (and being substantially free of a rubber like polymer) for increasing the Izod Notched impact strength at 23 °C (measured at a sample thickness of 3.2 mm or less according to ISO 180/4A) of a molded part of the polycarbonate composition to a value higher than 50 kJ/m², even higher than 60 kJ/m², and even higher than 70 kJ/m².

In one embodiment, such acid or acid salt is an inorganic acid or inorganic acid salt. In one embodiment, the composition contains a phosphorous containing oxy-acid and/or an acid salt thereof. Preferably, the phosphorous containing oxy-acid is a multi-protic phosphorus containing oxy-acid having the general formula HₘPₜOₙ, where m and n are each 2 or greater and t is 1 or greater. Examples of such acids include, but are not limited to, acids represented by the following formulas: H₃PO₄, H₃PO₃, and H₃PO₂. Non-limited examples of phosphorus containing oxy-acids are phosphoric acid, phosphorous acid, hypophosphorous acid, hypophosphoric acid, phosphinic acid, phosphonic acid, metaphosphoric acid, hexametaphosphoric acid, thiophosphoric acid, fluorophosphoric acid, difluorophosphoric acid, fluorophosphorous acid, difluorophosphorous acid, fluorohypophosphorous acid, or fluorohypophosphoric acid. In a preferred embodiment of the invention, the composition contains H₃PO₄, H₃PO₃, H₃PO₂ and/or an acid salt of H₃PO₄, H₃PO₃ or of H₃PO₂. In a more preferred embodiment of the invention, the composition contains H₃PO₄, H₃PO₃ and/or an acid salt of H₃PO₄ or of H₃PO₃. Non-limiting examples of acid salts of H₃PO₄ are mono zinc phosphate, mono calcium phosphate and mono natrium phosphate.. Preferably, component d) is H₃PO₄, H₃PO₃, H₃PO₂ and/or an acid salt of H₃PO₄, H₃PO₃ or of H₃PO₂ or a mixture thereof. More preferably, component d) is H₃PO₄, H₃PO₃, and/or an acid salt of H₃PO₄ or of H₃PO₃ or a mixture thereof.

The amount of acid and acid salt (different than the sulphonate salt) is preferably at least 0.001 wt.%, more preferably at least 0.01 wt.%, and even more preferably at least 0.015 wt.%, relative to the total amount of aromatic polycarbonate, laser direct structuring additive and sulphonate salt. The amount of acid and acid salt (different than the sulphonate salt) is at most 2 wt.%, preferably at most 1.5 wt.%, more preferably at most 1 wt.%, relative to the total amount of aromatic polycarbonate, laser direct structuring additive and sulphonate salt. In a particular preferred embodiment, the amount of acid and acid salt (different than the sulphonate salt) is from 0.01 up to and including 1 wt.%, relative to the total amount of aromatic polycarbonate, laser direct structuring additive and sulphonate salt.

The polycarbonate composition according to the invention may further comprise from 0 up to 25 mass% of one or more other additives, relative to the total weight of components a), b), c) and d). These include the customary additives such as stabilizers against thermal or thermo-oxidative degradation, stabilizers against hydrolytic degradation, stabilizers against degradation from light, in particular UV light, and/or photo-oxidative degradation, anti-drip agents such as for example PTFE, processing aids such as release agents and lubricants, colorants such as pigments and dyes, fillers including minerals such as wollastonite or aluminium silicates. Suitable examples of such additives and their customary amounts are stated in the aforementioned Kunststoff Handbuch, 3/1.

The polymer composition may further comprise reinforcing agents, such as glass fibres.

The components b), c) and d) (if present) and optionally other additives as described above, and also any other additives and reinforcing agents may be introduced into the aromatic polycarbonate by means of suitable mixing devices such as single-screw or twin-screw extruders, preferably a twin-screw extruder is used. Preferably, aromatic polycarbonate pellets are introduced into the extruder together with at least components b) and c) and extruded, then quenched in a water bath and then pelletized. The invention therefore further relates to a process for producing an aromatic polycarbonate composition according to the present invention by melt mixing components a), b), c) and optionally d) and other (particulate) additives and reinforcing agents.

The invention further relates to moulded parts that contains the polycarbonate composition according to the present invention. The invention relates in particular to a moulded part produced by injection moulding of the composition according to the invention. The invention further also relates to an article, in particular a circuit carrier, that contains a moulded part produced from the composition according to the invention. In one embodiment, such a circuit carrier is used for producing an antenna.

The invention further relates to a process for producing such a circuit carrier which process comprises the steps of providing a moulded part that contains the polycarbonate composition according to the present invention, irradiating areas of said part on which conductive tracks are to be formed with laser radiation to break down the LDS additive b) and releasing metal nuclei, and subsequently metallizing the irradiated areas. In a preferred embodiment, laser is used to simultaneously release metal nuclei and effect ablation of the part while forming an adhesion-promoting surface. This provides a simple means to achieve excellent adhesive strength of the deposited metallic conductor tracks.. The wavelength of the laser is advantageously 248 nm, 308 nm, 355 nm, 532 nm, 1064 nm or of even 10600 nm. The deposition of further metal onto the metal nuclei generated by laser radiation preferably takes place via plating processes. Said metallizing is preferably perfomed by immersing the moulded part in at least one electroless plating bath to form electrically conductive pathways on the irradiated areas of the moulded part. Non-limiting examples of electroless plating processes are a copper plating process, gold plating process, nickel plating process, silver plating, zinc plating and tin plating.

The invention will now be elucidated with reference to the following examples and comparative experiments.

### Examples 1-15 and Comparative Experiments A-M

The compositions of Comparative Experiments CEx A to CEx M and of the Examples Ex 1 to Ex 15 were prepared from the components as given in Table 1.

All sample compositions were prepared according the amounts as given in Table 2 to 6. All amounts are in weight percentage. In each of the experiments, samples were extruded on a co-rotating twin screw extruder at a temperature of 280°C. The extrudate was granulated and the collected granulate was injection moulded into ASTM-sized Izod bars (64*12.7*3.2 mm) using a melt temperature of approximately 290°C. Izod Notched impact strength was measured according to ISO180/4A at a temperature of 23°C and 0°C and the LVN (Limited Viscosity Number, ISO 1628/4) of the molded parts was measured for the non rubber containing samples (Table 2 to 4). For the samples of Table 5 ISO-sized Izod bars (80*10*4 mm) were molded in order to measure the Vicat B50 (Vicat Softening Temperature according ISO 306 with a load of 50 N at a rate of 50°C/hour) and for the samples of Table 6 UL bars with a thickness of 1.6 and 3.2 mm were molded in order to measure the UL94 V-rating (according IEC 60695-11-10 standard).

Table 2 shows the compositions and results of Comparative Examples (CEx) A to D and Examples (Ex) 1 to 5. Comparative Experiments CEx A and B are control samples to show that there is hardly any the effect on the materials' impact performance when a sulfonate salt (RM 65) is added to a Polycarbonate composition without the CuCr₂O₄ filler. Samples CEx C and D are Comparatrive Experiments to show that the impact performance is significantly decreased when the CuCr₂O₄ additive is added to a Polycarbonate composition like CEx A. The reason for this decrease in impact performance can be explained by the degradation of the polycarbonate caused by the presence of the CuCr₂O₄ additive, as can be seen from the LVN, which is a parameter for the molecular weight of the polycarbonate. Surprisingly, it has now been found that the Izod Notched impact strength is significantly increased upon the addition of the sulfonate salt (RM65), as seen for Example Ex 1 to Ex 5. Partly this seems to be related to a reduction in degradation of the polycarbonate, since the LVN of the Examples Ex 1 to 5 is increased compared to Comparative Experiments CEx C and D. However, the next set of examples will show that this increase in impact performance is not only related to the reduction in degradation.

Table 3 shows that the degradation of the polycarbonate due to the presence of the CuCr₂O₄ filler can be overcome by the addition of an acid (MZP), as the LVN of Comparative Experiments CEx G is almost at a similar level as the reference without the CuCr₂O₄ filler (CEx A). However the Izod Notched Impact strength of CEx G is only marginally increased compared to CEx D (from 7-8 kJ/m² to 12-14 kJ/m²). Comparative Experiments CEx E and F are control samples without the CuCr₂O₄ filler, showing the effect of an acid (MZP) on the LVN and Izod Notched impact strength. Interesting to see is that addition of the acid reduces both the LVN as well as the impact strength (compare CEx E with CEx A). A combination of acid and sulfonate salt even reduces these values significantly (compare CEx F with CEx B). The latter makes it even more surprisingly that when a combination of acid and sulfonate salt is added to a polycarbonate compound with the CuCr₂O₄ filler, the Izod Notched Impact strength is significantly improved, as can be seen for Examples Ex 6 to 8. The LVN values of these examples are not increased, thus the unexpected increase in impact performance can not be related to a decrease of degradation. It is even found that there is a synergistic effect between the acid (MZP) and sulfonate salt (RM 65) on the improvement of Izod Notched impact performance in a polycarbonate composition containing the CuCr₂O₄ additive, allowing to reduce either the acid or sulfonate salt percentage and still achieve good Izod Notched Impact values (see Ex 7 & Ex 8).

Table 4 illustrates that the Izod Notched Impact is also improved (compared to the control sample CEx D) upon the addition of KSS, which is a Potassium Diphenyl Sulfone Sulfonate instead of a Potassium Perfluoro Butane Sulfonate that was used in the experiments of Table 2 and 3. Similar to the results of the experiments in Table 2 and 3, a synergistic effect is observed for the combination of acid (MZP) and the KSS sulfonate salt.

Table 5 shows the effect of a sulfonate salt on the impact performance of a CuCr₂O₄ containing polycarbonate composition that also comprises a rubber like polymer (ABS and MBS). For a low level of rubber like polymer (1%) the addition of the sulfonate salt again improves the Izod Notched impact performance (compare Ex 13 and 14 with respectively CEx H and I). However for higher, and more practically used, levels of rubber like polymer (5% for MBS and 35% for ABS) no improvement in impact performance is seen anymore upon the addition of the sulfonate salt. Moreover the Vicat Softening temperature is decreasing upon the addition of more rubber like polymer, which is unbeneficial for applications that require higher temperature (e.g. for soldering).

Additionally, Table 6 shows the UL 94 flame retardant performance for several of the Comparative Experiments and Examples of Tables 2 and 3. It shows that the sulfonate salt is capable to improve the UL 94 to a V0 rating at a thickness of 3.2 mm. Example 15 was added to show that a combination of sulfonate salt and PTFE also enables to reach a V0 rating at a thickness of 1.6 mm, without loosing any Izod impact performance.

**Table 1**

| Material | Type | Supplier |
|---|---|---|
| Polycarbonate | LVN (ISO 1628/4) = 49 ml/g | DSM |
| ABS | Santac AT-05 | Mitsui Germany |
| MBS | Kane Ace M511 | Kaneka |
| CuCr₂O₄ | Black 1G | Shepherd Company |
| Mold release (MRA) | Loxiol P861/3.5 | Cognis |
| Heat Stabilizer (HS) | Irgafos 168 | Ciba |
| Potassium Perfluoro Butane Sulfonate | RM 65 | Miteni |
| Potassium Diphenyl Sulfone Sulfonate | KSS | Vertellus |
| Mono Zinc Phosphate (MZP) | Z 21-82 | Budenheim |

**Table 2**

| Sample | | CEx A | CEx B | CExC | CEx D | Ex 1 | Ex 2 | Ex 3 | Ex 4 | Ex 5 |
|---|---|---|---|---|---|---|---|---|---|---|
| Components | Units | | | | | | | | | |
| PC | % | 99.65 | 99.5 25 | 95.65 | 91.6 5 | 95.5 25 | 91.5 25 | 91.4 | 91.1 5 | 90.6 5 |
| CuCr₂O₄ | % | | | 4 | 8 | 4 | 8 | 8 | 8 | 8 |
| RM 65 | % | | 0.12 5 | | | 0.12 5 | 0.12 5 | 0.25 | 0.5 | 1 |
| MRA + HS | % | 0.35 | 0.35 | 0.35 | 0.35 | 0.35 | 0.35 | 0.35 | 0.35 | 0.35 |
| | | | | | | | | | | |

| Properties | | | | | | | | | | |
|---|---|---|---|---|---|---|---|---|---|---|
| Izod Notched (23°C) | kJ/m² | 83 | 81 | 11 | 8 | 80 | 11 | 67 | 68 | 31 |
| Izod Notched (0°C) | kJ/m² | 78 | 77 | 10 | 8 | 42 | 11 | 28 | 59 | 16 |
| LVN | ml/g | 50 | 49 | 43 | 37 | 50 | 43 | 46 | 46 | 41 |

**Table 3**

| Sample | | CEx E | CEx F | CEx G | Ex 6 | Ex 7 | Ex 8 |
|---|---|---|---|---|---|---|---|
| Components | Units | | | | | | |
| PC | % | 99.55 | 99.42 5 | 91.55 | 91.42 5 | 91.5 | 91.42 5 |
| CuCr₂O₄ | % | | | 8 | 8 | 8 | 8 |
| MZP | % | 0.1 | 0.1 | 0.1 | 0.1 | 0.1 | 0.02 |
| RM 65 | % | | 0.125 | | 0.125 | 0.05 | 0.125 |
| MRA + HS | % | 0.35 | 0.35 | 0.35 | 0.35 | 0.35 | 0.35 |
| | | | | | | | |

| Properties | | | | | | | |
|---|---|---|---|---|---|---|---|
| Izod Notched (23°C) | kJ/m² | 70 | 7 | 14 | 68 | 67 | 75 |
| Izod Notched (0°C) | kJ/m² | 12 | 8 | 12 | 44 | 22 | 66 |
| LVN | ml/g | 44 | 39 | 48 | 46 | 48 | 44 |

**Table 4**

| Sample | | CEx D | Ex 9 | Ex 10 | Ex 11 | Ex 12 |
|---|---|---|---|---|---|---|
| Components | Units | | | | | |
| PC | % | 91.65 | 91.15 | 90.65 | 91.35 | 91.05 |
| CuCr₂O₄ | % | 8 | 8 | 8 | 8 | 8 |
| MZP | % | | | | 0.1 | 0.1 |
| KSS | % | | 0.5 | 1 | 0.2 | 0.5 |
| MRA + HS | % | 0.35 | 0.35 | 0.35 | 0.35 | 0.35 |
| | | | | | | |

| Properties | | | | | | |
|---|---|---|---|---|---|---|
| Izod Notched (23°C) | kJ/m² | 8 | 62 | 69 | 64 | 67 |
| Izod Notched (0°C) | kJ/m² | 8 | 21 | 18 | 16 | 25 |
| LVN | ml/g | 37 | 47 | 46 | 45 | 46 |

**Table 5**

| Sample | | CEx H | Ex 13 | CEx I | Ex 14 | CEx J | CEx K | CEx L | CEx M |
|---|---|---|---|---|---|---|---|---|---|
| Components | Units | | | | | | | | |
| PC | % | 90.55 | 90.42 5 | 90.55 | 90.42 5 | 86.55 | 86.42 5 | 56,55 | 56,42 5 |
| ABS | % | 1 | 1 | | | | | 35 | 35 |
| MBS | % | | | 1 | 1 | 5 | 5 | | |
| CuCr₂O₄ | % | 8 | 8 | 8 | 8 | 8 | 8 | 8 | 8 |
| MZP | % | 0.1 | 0.1 | 0.1 | 0.1 | 0.1 | 0.1 | | |
| RM65 | % | | 0.125 | | 0.125 | | 0.125 | | 0.125 |
| MRA + HS | % | 0.35 | 0.35 | 0.35 | 0.35 | 0.35 | 0.35 | 0.35 | 0.35 |
| | | | | | | | | | |

| Properties | | | | | | | | | |
|---|---|---|---|---|---|---|---|---|---|
| Vicat | °C | 145 | 145 | 145 | 145 | 143 | 143 | 120 | 120 |
| Izod Notched (23°C) | kJ/m² | 9 | 72 | 70 | 71 | 64 | 60 | 36 | 38 |
| Izod Notched (0°C) | kJ/m² | 9 | 33 | 20 | 59 | 57 | 55 | 15 | 10 |

**Table 6**

| Sample | | CEx A | CEx B | CEx G | Ex 6 | Ex 15 |
|---|---|---|---|---|---|---|
| Components | Units | | | | | |
| PC | % | 99.65 | 99.52 5 | 91.55 | 91.42 5 | 91.22 5 |
| CuCr₂O₄ | % | | | 8 | 8 | 8 |
| MZP | % | | | 0.1 | 0.1 | 0.1 |
| RM65 | % | | 0.125 | | 0.125 | 0.125 |
| PTFE | % | | | | | 0.2 |
| MRA + HS | % | 0.35 | 0.35 | 0.35 | 0.35 | 0.35 |
| | | | | | | |

| Properties | | | | | | |
|---|---|---|---|---|---|---|
| Izod Notched (23°C) | kJ/m² | 83 | 81 | 14 | 68 | 68 |
| UL 94-V at 3.2 mm | - | V2 | V0 | V2 | V0 | V0 |
| UL 94-V at 1.6 mm | - | V2 | V2 | V2 | V2 | V0 |

The % in table 2-6 relate to the wt% of components relative to the total of the composition.

## Claims

1. Polycarbonate composition comprising:
a) aromatic polycarbonate in an amount higher than 85 wt%,
b) laser direct structuring additive in an amount of at least 0,5 wt%,
c) sulphonate salt in an amount of at least 0,001 wt.%, and
d) 0-2,4 wt.%. of rubber like polymer
wherein the mass% is calculated relative to the sum of components a), b), c) and d) .

2. Polycarbonate composition according to claim 1, wherein the Izod Notched impact strength at 23 °C (measured at a sample thickness of 3.2 mm or less according to ISO 180/4A) of a molded part of the polycarbonate composition is higher than 20 kJ/m².

3. Polycarbonate composition according to claim 1 or 2, wherein a molded part of the polycarbonate composition is capable of achieving UL94 V0 rating at a thickness of 3.2 mm (±10%).

4. Polycarbonate composition according to anyone of claims 1-3, wherein the Vicat B50 (Vicat Softening Temperature measured according to ISO 306 with a load of 50 N at a rate of 50°C/hour) of a molded part of the polycarbonate composition is higher than 140 °C.

5. Polycarbonate composition according to anyone of claims 1-4, wherein the composition comprises a copper containing spinel as laser direct structuring additive.

6. Polycarbonate composition according to any one of claims 1-5, wherein the composition comprises an alkali and/or earth alkali metal sulphonate as sulphonate salt.

7. Polycarbonate composition according to any one of claims 1-5, wherein the composition comprises a potassium sulphonate as sulphonate salt.

8. Polycarbonate composition according to any one of claims 1-5, wherein the composition comprises potassium perfluorobutane sulphonate and/or potassium diphenylsulphone sulphonate as sulphonate salt.

9. Polycarbonate composition according to any one of claims 1-5, wherein the composition comprises potassium perfluorobutane sulphonate as sulphonate salt.

10. Polycarbonate composition according to any one of the preceding claims, wherein the weight ratio of sulphonate salt to laser direct structuring additive is at least 0,01:1.

11. Polycarbonate composition according to any one of the preceding claims, wherein the weight ratio of sulphonate salt to laser direct structuring additive is at most 0.25:1.

12. Polycarbonate composition according to any one of the preceding claims, wherein the composition further comprises an acid and/or acid salt different than the sulphonate salt.

13. Polycarbonate composition according to claim 12, wherein the acid or acid salt is an inorganic acid or inorganic acid salt.

14. Polycarbonate composition according to claim 12, wherein the acid or acid salt is a phosphorous containing oxy-acid or an acid salt thereof.

15. Polycarbonate composition according to claim 12, wherein the phosphorous containing oxy-acid is H₃PO₄ and/or H₃PO₃

16. Moulded part that contains the polycarbonate composition according to any one of claims 1-15.

17. A circuit carrier that contains at least a moulded part according to claim 16.

18. Use of a sulphonate salt in a composition comprising aromatic polycarbonate and a laser direct structuring additive and being substantially free of a rubber like polymer for increasing the Izod Notched impact strength at 23 °C (measured at a sample thickness of 3.2 mm or less according to ISO 180/4A) of a molded part of the polycarbonate composition.

19. Use of a sulphonate salt and an acid and/or acid salt (different than the sulphonate salt) in a composition comprising aromatic polycarbonate and a laser direct structuring additive and being substantially free of a rubber like polymer for increasing the Izod Notched impact strength at 23 °C (measured at a sample thickness of 3.2 mm or less according to ISO 180/4A) of a molded part of the polycarbonate composition.

20. Use according to anyone of claims 18-19, wherein the sulphonate salt is a potassium sulphonate.

21. Use according to anyone of claims 18-20, wherein the acid is an inorganic acid or inorganic acid salt.

22. Use according to anyone of claims 18-20, wherein the acid is a phosphorous containing oxy-acid and/or an acid salt thereof.

## Patentansprüche

1. Polycarbonatzusammensetzung, umfassend:
a) aromatisches Polycarbonat in einer Menge von mehr als 85 Gew.-%,
b) Laser-Direkt-Strukturierungs-Zusatzstoff in einer Menge von mindestens 0,5 Gew.-%,
c) Sulfonatsalz in einer Menge von mindestens 0,001 Gew.-%, und
d) 0 bis 2,4 Gew.-% kautschukähnliches Polymer
wobei der Massenprozentanteil bezogen auf die Summe der Bestandteile a), b), c) und d) berechnet wird.

2. Polycarbonatzusammensetzung nach Anspruch 1, wobei die Izod-Kerbschlagzähigkeit bei 23 °C (gemessen bei einer Probendicke von 3,2 mm oder weniger gemäß ISO 180/4A) eines Formteils der Polycarbonatzusammensetzung höher als 20 kJ/m² ist.

3. Polycarbonatzusammensetzung nach Anspruch 1 oder 2, wobei ein Formteil der Polycarbonatzusammensetzung eine Einstufung von V0 gemäß UL94 bei einer Dicke von 3,2 mm (±10%) erreichen kann.

4. Polycarbonatzusammensetzung nach einem der Ansprüche 1 bis 3, wobei die Vicat B50 (Vicat-Erweichungstemperatur, die gemäß ISO 306 bei einer Last von 50 N bei einer Rate von 50 °C/Stunde gemessen wird) eines Formteils der Polycarbonatzusammensetzung höher als 140 °C ist.

5. Polycarbonatzusammensetzung nach einem der Ansprüche 1 bis 4, wobei die Zusammensetzung einen kupferhaltigen Spinnel als Laser-Direkt-Strukturierungs-Zusatzstoff umfasst.

6. Polycarbonatzusammensetzung nach einem der Ansprüche 1 bis 5, wobei die Zusammensetzung ein Alkali- und/oder Erdalkalimetallsulfonat als Sulfonatsalz umfasst.

7. Polycarbonatzusammensetzung nach einem der Ansprüche 1 bis 5, wobei, die Zusammensetzung ein Kaliumsulfonat als Sulfonatsalz umfasst.

8. Polycarbonatzusammensetzung nach einem der Ansprüche 1 bis 5, wobei die Zusammensetzung Kaliumperfluorbutansulfonat und/oder Kaliumdiphenylsulfonsulfonat als Sulfonatsalz umfasst.

9. Polycarbonatzusammensetzung nach einem der Ansprüche 1 bis 5, wobei, die Zusammensetzung Kaliumperfluorbutansulfonat als Sulfonatsalz umfasst.

10. Polycarbonatzusammensetzung nach einem der vorhergehenden Ansprüche, wobei das Gewichtsverhältnis von Sulfonatsalz zu Laser-Direkt-Strukturierungs-Zusatzstoff mindestens 0,01:1 beträgt.

11. Polycarbonatzusammensetzung nach einem der vorhergehenden Ansprüche, wobei das Gewichtsverhältnis von Sulfonatsalz zu Laser-Direkt-Strukturierungs-Zusatzstoff höchstens 0,25:1 beträgt.

12. Polycarbonatzusammensetzung nach einem der vorhergehenden Ansprüche, wobei die Zusammensetzung ferner eine Säure und/oder ein Säuresalz umfasst, die bzw. das von dem Sulfonatsalz verschieden ist.

13. Polycarbonatzusammensetzung nach Anspruch 12, wobei die Säure oder das Säuresalz eine anorganische Säure oder ein anorganisches Säuresalz ist.

14. Polycarbonatzusammensetzung nach Anspruch 12, wobei die Säure oder das Säuresalz eine phosphorhaltige Oxysäure oder ein Säuresalz davon ist.

15. Polycarbonatzusammensetzung nach Anspruch 12, wobei die phosphorhaltige Oxysäure H₃PO₄ und/oder H₃PO₃ ist.

16. Formteil, das die Polycarbonatzusammensetzung nach einem der Ansprüche 1 bis 15 enthält.

17. Schaltungsträger, der mindestens ein Formteil nach Anspruch 16 enthält.

18. Verwendung eines Sulfonatsalzes in einer Zusammensetzung, die aromatisches Polycarbonat und einen Laser-Direkt-Strukturierungs-Zusatzstoff umfasst und im Wesentlichen frei von einem kautschukähnlichen Polymer ist, um die Izod-Kerbschlagzähigkeit bei 23 °C (gemessen bei einer Probendicke von 3,2 mm oder weniger gemäß ISO 180/4A) eines Formteils der Polycarbonatzusammensetzung zu erhöhen.

19. Verwendung eines Sulfonatsalzes und einer Säure und/oder eines Säuresalzes (die bzw. das von dem Sulfonatsalz verschieden ist) in einer Zusammensetzung, die aromatisches Polycarbonat und einen Laser-Direkt-Strukturierungs-Zusätzstoff umfasst und im Wesentlichen frei von einem kautschukähnlichen Polymer ist, um die Izod-Kerbschlagzähigkeit bei 23 °C (gemessen bei einer Probendicke von 3,2 mm oder weniger gemäß ISO 180/4A) eines Formteils der Polycarbonatzusammensetzung zu erhöhen.

20. Verwendung nach einem der Ansprüche 18 bis 19, wobei das Sulfonatsalz ein Kaliumsulfonat ist.

21. Verwendung nach einem der Ansprüche 18 bis 20, wobei die Säure eine anorganische Säure oder ein anorganisches Säuresalz ist.

22. Verwendung nach einem der Ansprüche 18 bis 20, wobei die Säure eine phosphorhaltige Oxysäure und/oder ein Säuresalz davon ist.

## Revendications

1. Composition de polycarbonate comprenant :
a) un polycarbonate aromatique en une quantité supérieure à 85 % en poids,
b) un additif de structuration directe par laser en une quantité d'au moins 0,5 % en poids,
c) un sel de sulfonate en une quantité d'au moins 0,001 % en poids, et
d) de 0 à 2,4 % en poids de polymère de type caoutchouc
dans laquelle le % en poids est calculé par rapport à la somme des composants a), b), c) et d).

2. Composition de polycarbonate selon la revendication 1, dans laquelle la résistance au choc sur barreau entaillé IZOD à 23 °C (mesurée pour une épaisseur d'échantillon de 3,2 mm ou moins selon la norme ISO 180/4A) d'une partie moulée de la composition de polycarbonate est supérieure à 20 kJ/m².

3. Composition de polycarbonate selon la revendication 1 ou 2, dans laquelle une partie moulée de la composition de polycarbonate est capable d'obtenir un score V0 selon UL94 pour une épaisseur de 3,2 mm (± 10 %).

4. Composition de polycarbonate selon l'une quelconque des revendications 1 à 3, dans laquelle le point de ramollissement Vicat selon la méthode B50 (point de ramollissement Vicat mesuré selon la norme ISO 306 avec une charge de 50 N à un taux de 50 °C/heure) d'une partie moulée de la composition de polycarbonate est supérieur à 140 °C.

5. Composition de polycarbonate selon l'une quelconque des revendications 1 à 4, dans laquelle la composition comprend un spinelle contenant du cuivre en tant qu'additif de structuration directe par laser.

6. Composition de polycarbonate selon l'une quelconque des revendications 1 à 5, dans laquelle la composition comprend un sulfonate de métal alcalin et/ou alcalino-terreux en tant que sel de sulfonate.

7. Composition de polycarbonate selon l'une quelconque des revendications 1 à 5, dans laquelle la composition comprend un sulfonate de potassium en tant que sel de sulfonate.

8. Composition de polycarbonate selon l'une quelconque des revendications 1 à 5, dans laquelle la composition comprend un perfluorobutanesulfonate de potassium et/ou un diphénylsulfonesulfonate de potassium en tant que sel de sulfonate.

9. Composition de polycarbonate selon l'une quelconque des revendications 1 à 5, dans laquelle la composition comprend un perfluorobutanesulfonate de potassium en tant que sel de sulfonate.

10. Composition de polycarbonate selon l'une quelconque des revendications précédentes, dans laquelle le rapport en poids du sel de sulfonate à l'additif de structuration directe par laser est d'au moins 0,01:1.

11. Composition de polycarbonate selon l'une quelconque des revendications précédentes, dans laquelle le rapport en poids du sel de sulfonate à l'additif de structuration directe par laser est d'au plus 0,25:1.

12. Composition de polycarbonate selon l'une quelconque des revendications précédentes, dans laquelle la composition comprend en outre un acide et/ou un sel d'acide différent du sel de sulfonate.

13. Composition de polycarbonate selon la revendication 12, dans laquelle l'acide ou le sel d'acide est un acide inorganique ou un sel d'acide inorganique.

14. Composition de polycarbonate selon la revendication 12, dans laquelle l'acide ou le sel d'acide est un oxyacide contenant du phosphore ou un sel d'acide de celui-ci.

15. Composition de polycarbonate selon la revendication 12, dans laquelle l'oxyacide contenant du phosphore est H₃PO₄ et/ou H₃PO₃.

16. Partie moulée qui contient la composition de polycarbonate selon l'une quelconque des revendications 1 à 15.

17. Support de circuit qui contient au moins une partie moulée selon la revendication 16.

18. Utilisation d'un sel de sulfonate dans une composition comprenant un polycarbonate aromatique et un additif de structuration directe par laser et qui est sensiblement exempte de polymère de type caoutchouc pour augmenter la résistance au choc sur barreau entaillé IZOD à 23 °C (mesurée pour une épaisseur d'échantillon de 3,2 mm ou moins selon la norme ISO 180/4A) d'une partie moulée de la composition de polycarbonate.

19. Utilisation d'un sel de sulfonate et d'un acide et/ou d'un sel d'acide (différent du sel de sulfonate) dans une composition comprenant un polycarbonate aromatique et un additif de structuration directe par laser et qui est sensiblement exempte de polymère de type caoutchouc pour augmenter la résistance au choc sur barreau entaillé IZOD à 23 °C (mesurée pour une épaisseur d'échantillon de 3,2 mm ou moins selon la norme ISO 180/4A) d'une partie moulée de la composition de polycarbonate.

20. Utilisation selon l'une quelconque des revendications 18 à 19, dans laquelle le sel de sulfonate est un sulfonate de potassium.

21. Utilisation selon l'une quelconque des revendications 18 à 20, dans laquelle l'acide est un acide inorganique ou un sel d'acide inorganique.

22. Utilisation selon l'une quelconque des revendications 18 à 20, dans laquelle l'acide est un oxyacide contenant du phosphore ou un sel d'acide de celui-ci.
